(19) Europäisches Patentamt

European Patent Office

Office européen des brevets

(11) **EP 0 622 853 B1**

(12) **EUROPEAN PATENT SPECIFICATION**

(45) Date of publication and mention
of the grant of the patent:
**12.02.2003 Bulletin 2003/07**

(51) Int Cl.⁷: **H01L 29/739**

(21) Application number: **94105178.1**

(22) Date of filing: **31.03.1994**

(54) **Insulated gate bipolar transistor**

Bipolartransistor mit isoliertem Gate

Transistor bipolaire à grille isolée

(84) Designated Contracting States:
**DE FR GB**

(30) Priority: **02.04.1993 JP 7675993**

(43) Date of publication of application:
**02.11.1994 Bulletin 1994/44**

(73) Proprietor: **DENSO CORPORATION**
**Kariya-City, Aichi-Pref. (JP)**

(72) Inventors:
• **Okabe, Naoto**
**Higashiura-cho, Chita-gun, Aichi (JP)**
• **Kato, Naohito**
**Kariya-shi, Aichi (JP)**

(74) Representative:
**Winter, Brandl, Fürniss, Hübner, Röss, Kaiser,**
**Polte Partnerschaft**
**Patent- und Rechtsanwaltskanzlei**
**Alois-Steinecker-Strasse 22**
**85354 Freising (DE)**

(56) References cited:
EP-A- 0 156 022      EP-A- 0 293 846
EP-A- 0 501 342      EP-A- 0 503 605
DE-A- 4 022 021      GB-A- 2 240 427

• **SOLID STATE ELECTRONICS. vol. 35, no. 5 , May**
**1992 , OXFORD GB pages 681 - 685 T. LASKA ET**
**AL. 'A 2000 V NON-PUNCHTHROUGH IGBT WITH**
**HIGH RUGGEDNESS'**
• **PATENT ABSTRACTS OF JAPAN vol. 009, no.**
**169 (E-328) 13 July 1985 & JP 60 043 862 A**
**(HITACHI SEISAKUSHO KK) 08 June 1985**

## EP 0 622 853 B1

**Description**

BACKGROUND OF THE INVENTION

1. Field of the Invention

The present invention relates to an insulated gate bipolar transistor (hereinafter referred to as "IGBT") integrating an anti-excess voltage protection function and a drain voltage fixing function.

2. Description of the Related Art

Upon turning OFF a power switching element employed as an inverting device for a motor circuit or non-interruptible power supply circuit, a high voltage can be induced in an inductive load or a floating inductance in the circuit due to the abrupt change of current flowing through the circuit. This high voltage is applied to the power switching element as a spike voltage to cause fatigue or breakage of the power switching element. To protect the power switching element from excess voltage, a voltage clamp circuit including a constant voltage diode based on the principle of avalanche breakdown for turning ON the constant voltage diode before breakdown occurs in the power switching element because of applied spike voltage and thus fixing the level of the spike voltage within a safe operation range, is employed.

When an IGBT is employed as the power switching element, a similar means can be applied. Namely, the constant voltage diode is externally connected between the drain and gate of the IGBT element. However, this increases both the assembling cost and the overall device size. It is also possible that a layer of polycrystalline silicon is deposited on a substrate, in which an IGBT element has been formed, and a constant voltage diode is then formed in this polycrystalline silicon layer integrally with the IGBT element. This increases the number of photo-masks necessary in the element fabrication process leading to an increase in the production cost. Furthermore, in order to form the constant voltage diode on the surface of the IGBT element, it is necessary either to reduce the area of the cell region or to increase the chip dimensions.

As a solution to this problem, JP-A-1 081 270 proposes a method of integrating a constant voltage diode, in which method the constant voltage diode based on the principle of avalanche breakdown is incorporated in the IGBT element so that the constant voltage diode is interposed between the drain and the source in an equivalent circuit. This solves the problems such as the reduction of the chip area of the IGBT element.

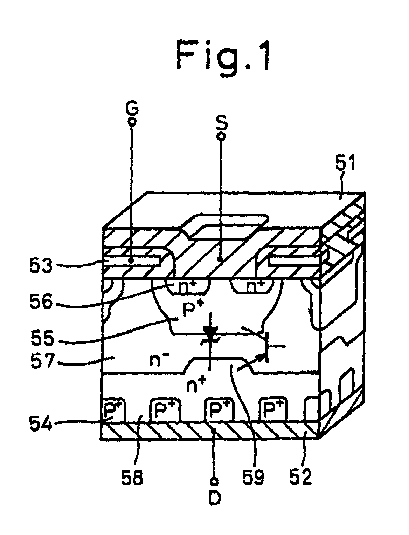

The proposed method provides a construction as shown in Fig. 1, including a source electrode 51, a drain electrode 52 and a gate electrode 53. The upper portion of the construction is composed of an insulating gate having a DSA (diffused self-aligned) structure, a $p^+$ base layer 55, and an $n^+$ source layer 56, thereby forming a p-type channel region immediately below the gate. It can also be seen that the construction has a vertical npnp-lamination of four layers, i.e., the $n^+$ source layer 56, the $p^+$ base layer 55, an $n^-$ drain layer 57, and a $p^+$ drain layer 54 located between an $n^+$ layer 58 and the drain electrode 52.

The $p^+$ drain layer 54, on the side of the drain electrode 52, is divided into small segments forming a honeycomb-like array, to provide a structure in which a vertical pnp transistor having the collector and the emitter between which a p-n junction diode is connected in parallel. The diode has a portion 59 of the $n^+$ layer that protrudes into the $n^-$ layer 57 to be close to the $p^+$ layer 55, to provide avalanche type constant voltage diode characteristics, thereby protecting the IGBT element from excess voltage.

To incorporate the constant voltage diode, the proposed construction must have an $n^+$ layer 58 on the drain side thereof. The presence of the $n^+$ layer 58 suppresses hole injection from the drain side upon conducting the IGBT element and thereby causes the ON voltage to be increased.

Moreover, the construction is complicated because of the honeycomb structure of the $p^+$ layer 54 on the side of the drain electrode 52 and because of the portion 59 of the $n^+$ layer 58 that protrudes into the $n^-$ drain layer 57. This raises both the wafer and production costs.

Document EP-A-0 503 605, on which the preamble of independent claim 1 is based, refers to an insulated gate bipolar transistor having a first layer, a second layer, a third layer and a fourth layer laminated respectively in order to define the vertical IGBT structure. This IGBT structure is surrounded by a fifth layer defining a guard ring. A gate electrode is formed on a channel region adjacent to the surface of the third layer extending between the second and the fourth layer via a gate insulation layer. A source electrode contacts both the third and fourth layer, while a drain electrode contacts the first layer.

Document EP-A-0 156 022 discloses an IGBT not including a guard ring and having an avalanche breakdown voltage lower than a punch-through voltage.

Document GB-A-2 240 427 is directed to guard ring structures used in MOSFET cell units in order to improve breakdown voltages.

Finally, document JP-A-60 043 862 discloses a vertical DMOSFET having a guard ring structure.

It is an object of the present invention to provide an IGBT having a guard ring structure and an anti-excess voltage protection and a drain voltage-fixing function together with a function to clamp the drain-source voltage in a monolithic structure without the drawback of increasing the ON voltage.

According to the present invention, this object is achieved by the measures indicated in present claim 1.

The dependent claims describe particular embodiments of the invention.

The advantages of the invention will become apparent and obvious to those skilled in the art upon referring to the following description provided in connection with the accompanying drawings.

BRIEF DESCRIPTION OF THE DRAWINGS

Figure 1 shows a conventional IGBT integrating therein a constant voltage diode operating based on the principle of avalanche breakdown, in a perspective view of a partial section;

Fig. 2 shows a unit cell portion and a circumferential guard ring portion of an IGBT according to a preferred embodiment of the present invention, in a sectional view;

Fig. 3 shows a unit cell portion and a circumferential guard ring portion of an IGBT according to another preferred embodiment of the present invention, in a sectional view;

Fig. 4 is a graph showing the electric characteristic of the IGBT shown in Fig. 2; and

Fig. 5 is a graph showing the electric characteristic of the IGBT shown in Fig. 3.

DESCRIPTION OF THE PREFERRED EMBODIMENTS

The operation of the IGBT according to the present invention will be described, particularly concerning an n-channel IGBT.

When a positive voltage is applied to a drain electrode relative to a source electrode, a p-n junction defined between an n-type second semiconductor layer and a p-type third semiconductor layer is brought into a reverse biased condition, so that a depletion region propagates from this p-n junction. When the n-type second semiconductor layer has a lower impurity concentration in comparison with the p-type third semiconductor layer, the depletion region propagates through the n-type second semiconductor layer toward the p-type first semiconductor layer, as the applied voltage between the source and drain electrodes increases. The electrical field in the depletion region also increases with the increase in the source-drain voltage.

When the electrical field reaches a critical value which causes generation of a great number of electron-hole pairs in the depletion region by impact ionization, the thus-generated holes flow through the p-type third semiconductor layer to the source electrode while the generated electrons flow toward a p-n junction defined between the p-type first semiconductor layer and the n-type second semiconductor layer. This reduces a potential barrier formed by a diffusion potential at this p-n junction, so that holes or minority carriers from the p-type first semiconductor layer are injected into the n-type second semiconductor layer, pass through the depletion region and the p-type third semiconductor layer, and flow to the source electrode. When passing through the depletion region, the holes are accelerated by the electrical field in the depletion region to obtain a large kinetic energy, thereby further generating new electron-hole pairs due to impact ionization.

With the mechanism as described above, a current abruptly begins to flow between the source electrode and the drain electrode to suppress an increase in the voltage between the source electrode and the drain electrode. This is known as a breakdown phenomenon in the bipolar transistor that occurs because the maximum electrical field, established near the base-collector p-n junction when the base electrode is open, reaches a critical electrical field. The present invention applies this phenomenon to the IGBT.

The voltage $V_{BDS}$ between the source electrode and the drain electrode, at which the current abruptly begins to flow, is an applied voltage at which the electrical field in the IGBT element reaches a critical electrical field that causes the breakdown phenomenon. It has been found that the $V_{BDS}$ value depends on the impurity concentration $N_{DND}$ of the n-type second semiconductor layer and that the smaller the $N_{DND}$, the greater the $V_{BDS}$. Therefore, the voltage $V_{BDS}$ can be set to desired values by selecting the $N_{DND}$ value of the second semiconductor layer. Namely, the IGBT element is protected from excess voltage by setting the impurity concentration of the n-type second semiconductor layer to a selected value such as to provide a $V_{BDS}$ value falling within a safe operation range of the element.

Because of the accompanying rapid increase in the drain current, the source-drain voltage is fixed at or near a particular voltage. Thus, the IGBT structure according to the present invention internally incorporates the function for preventing the source-drain voltage from rising above a given value while fixing the source-drain voltage within a particular range.

Preferably, the IGBT element according to the present invention further comprises an n-type sixth semiconductor layer which is disposed at or near a p-n junction between the p-type first semiconductor layer and the n-type second semiconductor layer, has an impurity concentration higher than that of the second semiconductor layer, and is patterned so as to leave a contact surface between the first semiconductor layer and the second semiconductor layer for transferring carriers therethrough. This feature advantageously restricts injection of the minority carriers (holes) from the p-type first semiconductor layer into the n-type second semiconductor layer through the p-n junction therebetween when a large number of electron-hole pairs are generated, thereby restricting the formation of a conductivity modulated region and the reduction of resistance due to the injection of the holes. As a result, when the drain current rises, fluctuation of drain voltage because of conductivity modulation, caused by an injection of minority carriers, can be suppressed to stabilize the drain voltage when the current begins to flow through the element.

Thus, the present invention uses the operation principle that the second semiconductor layer has an impurity concentration set at a selected value to induce a breakdown in a vertically laminated triple layer structure composed of third, second and first semiconductor layers in an IGBT element under a condition suitable for clamping the drain-source voltage. This makes it unnecessary to incorporate a constant voltage diode in an IGBT element, in contrast with the conventional IGBT structure disclosed in JP-A-1 081 270. Therefore, the present invention is advantageous over said conventional IGBT in that the IGBT element incorporates an anti-excess voltage protection function and a drain voltage fixing function together with a drain-source voltage clamping function in a monolithic structure, without causing an increase in the ON voltage.

The present invention will now be described in more detail by way of examples for an n-channel IGBT employing p- and n-types as the first and second conductivity types, respectively.

Example 1

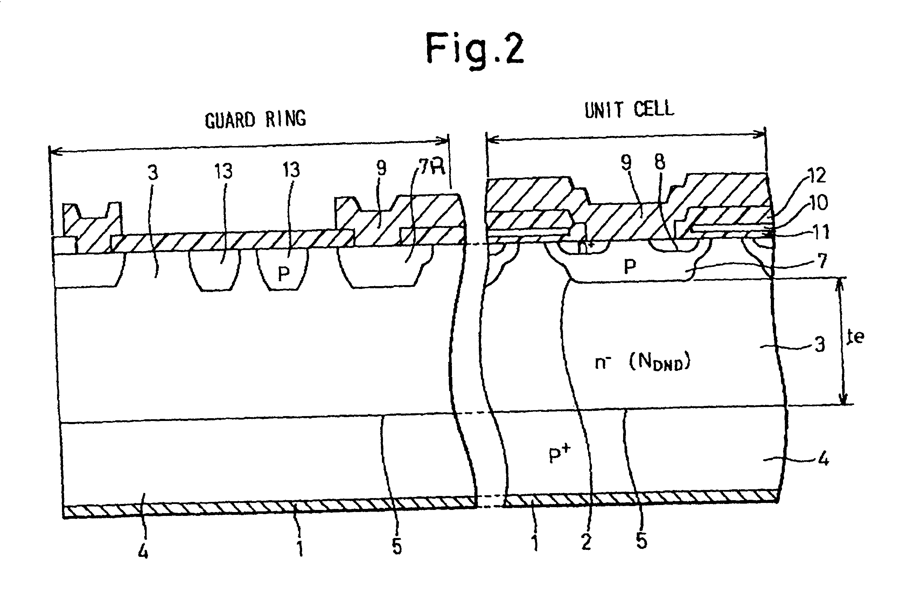

Figure 2 shows a unit cell portion and a circumferential guard ring portion of an IGBT according to the first embodiment of the present invention, the guard ring surrounding the unit cell. The IGBT is fabricated in the following process.

First, a semiconductor substrate or a $p^+$ drain layer 4 (first semiconductor layer) is prepared. A high resistivity $n^-$ drain layer 3 (second semiconductor layer) with a selected impurity concentration $N_{DND}$ and layer thickness $t_e$ is then formed by vapor deposition or other vapor phase growth process. A p base layer 7 (third semiconductor layer) and a p layer 13 (fifth semiconductor layer) are simultaneously formed to a depth of 3 to 6 $\mu$m by a selective diffusion process. The p layer 13 is a guard ring to provide high breakdown voltage. An $n^+$ source layer (fourth semiconductor layer) is formed in the p base layer 7 by selective diffusion process. It should be noted that, during the above-mentioned forming process, the $n^-$ drain layer 3 is oxidized in the surface portion to form a gate oxide film 11, on which a gate electrode 10 is then formed and is used as a mask for forming the p base layer 7 and an $n^+$ source layer 8 in a self-aligning manner by a DSA (Diffusion Self-Alignment) process to provide a channel region. Thereafter, an interlayer insulation layer 12 is formed. Subsequently, to provide an ohmic contact in the p base layer 7 and the $n^+$ source layer 8, contact holes are opened through the gate oxide layer 11 and the interlayer insulation layer 12. Deposition of several $\mu$m of aluminum and selective etching are then performed to form a source electrode 9 and a not-shown gate electrode pad. Then, a metal film is deposited on the reverse side of the semiconductor substrate or $p^+$ drain layer 4 to form a drain electrode 1.

The $n^-$ drain layer 3 has an impurity concentration $N_{DND}$ and a layer thickness $t_e$ such that breakdown occurs in the triple layer structure composed of the p base layer 7, the $n^-$ drain layer 3 and the $p^+$ drain layer 4 at a voltage smaller than a source-drain proof voltage $V_{GR}$ determined by the structure of the circumferential guard ring.

Specifically, the $n^-$ layer 3 (second semiconductor layer of the second conductivity type) has an impurity concentration and a layer thickness such that, when a voltage is applied across the drain electrode 1 and the source electrode 9 to propagate a depletion zone from the surface of a p-n junction 2 between the p base layer 7 (third semiconductor layer of the first conductivity type) and the $n^-$ layer 3 (second semiconductor layer) toward inside of the $n^-$ layer 3 (second semiconductor layer), a critical electric field is established that causes generation of a great number of electron-hole pairs due to impact ionization of carriers in or near the $n^-$ layer 3 (second semiconductor layer), thereby causing conduction between the drain electrode 1 and the source electrode 9, at an applied voltage lower than a drain-source voltage at which the depletion region reaches the $p^+$ drain layer (first semiconductor layer of the first conductivity type) through the $n^-$ layer 3 (second semiconductor layer), the applied voltage being lower than a critical voltage that causes generation of a great number of electron-hole pairs due to impact ionization of carriers in or near the $n^-$ layer 3 (second semiconductor layer) below a p-n junction between the p layer or guard ring 13 (fifth semiconductor layer of the first conductivity type) and the $n^-$ layer 3 (second semiconductor layer).

The thus-fabricated IGBT has an anti-excess voltage protection function and a drain voltage fixing function, as described in detail below.

When a positive voltage $V_D$ is applied to the drain electrode 1 while maintaining the potential at the source electrode 9 and the gate electrode 10 on the ground level, a depletion region is formed in the n⁻ drain layer 3 because of reverse bias at the p-n junction 2 defined between the p base layer 7 and the n⁻ drain layer 3. This depletion region propagates within the n⁻ drain layer 3 toward the p⁺ drain layer 4 as the voltage $V_D$ increases. The electrical field in the depletion region also increases with the increase in the source-drain voltage.

When the electrical field reaches a critical value $E_B$ which causes generation of a great number of electron-hole pairs in the depletion region by impact ionization, the thus-generated holes flow through the p base layer 7 to the source electrode 9 while the generated electrons flow toward a p-n junction 5 defined between the p⁺ drain layer 4 and the n⁻ drain layer 3. This reduces a potential barrier formed by a diffusion potential at this p-n junction, so that holes or minority carriers from the p⁺ drain layer 4 are injected into the n⁻ drain layer 3, pass through the depletion region and the p base layer, and flow to the source electrode 9. When passing through the depletion region, the holes are accelerated by the electrical field in the depletion region to obtain a large kinetic energy, thereby further generating new electron-hole pairs due to impact ionization.

With the mechanism as described above, breakdown phenomenon is induced by the p-n-p triple layer structure composed of the p base layer 7, the n⁻ drain layer 3 and the p⁺ drain layer 4, so that a current abruptly begins to flow between the source electrode 9 and the drain electrode 1 to suppress an increase in the voltage between the source electrode 9 and the drain electrode 1.

Because of the accompanying rapid increase in the drain current, the source-drain voltage is fixed at a particular voltage $V_{BDS}$ or around as hereinbefore described, so that a drain voltage fixing function is provided.

The breakdown operation, which is performed by the p-n-p triple layer structure composed of the p base layer 7, the n⁻ drain layer 3 and the p⁺ drain layer 4, is qualitatively interpreted by the breakdown effected between the emitter and the collector of a pnp bipolar transistor with the base terminal opened.

The breakdown voltage $V_{BDS}$ is expressed by the following formula (1) in terms of the avalanche breakdown voltage $V_{Bpn}$ of a p-n junction defined by the p base layer 7 and the n⁻ drain layer 3 (e.g., the p-type collector and the n-type base in a pnp bipolar transistor) and the current amplification factor $h_{FE}$ of a pnp triple layer bipolar transistor.

$$V_{BDS} = V_{Bpn}/(h_{FE})^{1/n} \qquad (1)$$

where "n" is a constant which depends on the material and structure.

In a p-n⁻ junction in the form of a one-sided step junction, the avalanche breakdown voltage $V_{Bpn}$ of the p-n junction is expressed by the following formula (2) in terms of the specific dielectric constant $K_S$ of the material, the permittivity of vacuum $\varepsilon_0$, the critical electric field $E_{CRIT}$ at which the avalanche breakdown occurs, the elementary charge q, and the impurity concentration $N_{DND}$ of the n⁻ drain layer 3.

$$V_{Bpn} = K_S \times \varepsilon_0 \times E_{CRIT}^2 / (2 \times q \times N_{DND}) \qquad (2)$$

Substituting formula (2) into formula (1) yields the following formula (3).

$$V_{BDS} = K_S \times \varepsilon_0 \times E_{CRIT}^2 / (2 \times q \times N_{DND} \times (h_{FE})^{1/n}) \qquad (3)$$

This shows that the breakdown voltage $V_{BDS}$ is determined by the impurity concentration $N_{DND}$ and the current amplification constant $h_{FE}$.

The $h_{FE}$ value depends on the layer thickness $t_e$ and impurity concentration $N_{DND}$ of the n⁻ drain layer 3, which corresponds to the base region of a pnp triple layer bipolar transistor.

Therefore, the breakdown voltage $V_{BDS}$ of a pnp triple layer structure composed of the p base layer 7, the n⁻ drain layer 3 and the p⁺ drain layer 4 can be set to a desired value lower than the source-drain breakdown voltage determined by the circumferential guard ring structure surrounding the unit cell, by selecting the impurity concentration $N_{DND}$ and layer thickness $t_e$ of the n⁻ drain layer 3.

The present invention has the following advantageous effect. The impurity concentration $N_{DND}$ and layer thickness $t_e$ of the n⁻ drain layer 3 is selected so as to cause breakdown to occur in the unit cell region at a voltage not higher than $V_{GR}$. It should be also noted that, when the electrical field $E_U$ of the unit cell region is a little greater than the electrical field $E_{GR}$ of the guard ring region, the high electical field region of the unit cell has an area greater than that of the high electical field region of the guard ring, with respect to a plan view of a device chip, so that the unit cell region has a large number of impact-ionized carriers to allow a large electrical current to flow therethrough such that substantial electrical conduction is effected by the breakdown of the unit cell. This makes it possible that the circumferential portion of a unit cell has a higher breakdown voltage than the core portion of the unit cell to realize a high proof voltage IGBT. It should be also appreciated that breakdown does not occur in the guard ring portion but occurs in the unit cell region, so that the occurrence of breakdown is not limited to near the guard ring portion as was conventionally encountered, and therefore an excess voltage can be absorbed in a broad cell region over the whole chip area. As the result, the current flowing through the chip upon breakdown is made uniform, so that the occurrence of hot spots or other problems are eliminated.

Example 2

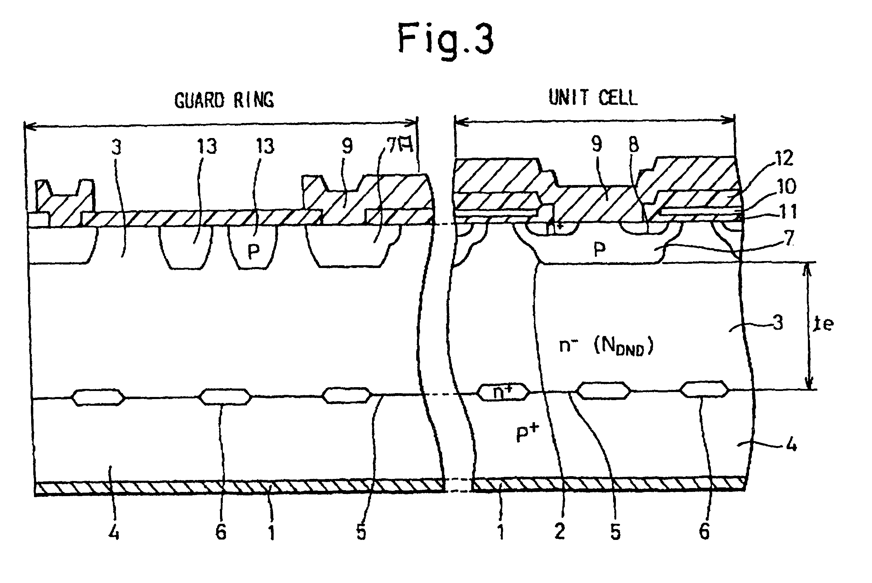

Figure 3 shows a unit cell portion and an outer circumferential guard ring portion of an IGBT according to another preferred embodiment of the present invention, in a sectional view. This IGBT has the same structure as that of Example 1, except that an $n^+$ layer 6 (sixth semiconductor layer) in the form of a periodic repeated pattern of stripes is selectively formed near the substrate p-n junction 5. The $n^+$ layer 6 can be formed near the substrate p-n junction 5, either by selective diffusion of an n-type impurity into the surface of the semiconductor substrate or $p^+$ drain layer 4, or by forming an $n^-$ layer on the surface of the $p^+$ drain layer 4 followed by selective diffusion of an n-type impurity into the surface of the $n^-$ layer, prior to the step of forming the $n^-$ drain layer 3 and the subsequent process steps as described in Example 1. In Fig. 3, the corresponding components are denoted by the same reference numerals as those in Fig. 2.

The thus-fabricated IGBT has an excess-drain voltage protection function and a drain voltage fixing function, as described in detail below.

When a positive voltage $V_D$ is applied to the drain electrode 1 while maintaining the potential at the source electrode 9 and the gate electrode 10 on the ground level, a depletion region is formed in the $n^-$ drain layer 3 because of reverse vias at the p-n junction 2 defined between the p base layer 7 and the $n^-$ drain layer 3. This depletion region propagates within the $n^-$ drain layer 3 toward the $p^+$ drain layer 4 as the voltage $V_D$ increases. The electrical field in the depletion region also increases with the increase in the source-drain voltage.

When the electrical field reaches a critical value $E_B$ which causes generation of a great number of electron-hole pairs in the depletion region by impact ionization, the thus-generated holes flow through the p base layer 7 to the source electrode 9 while the generated electrons flow toward a p-n junction 5 defined between the $p^+$ drain layer 4 and the $n^-$ drain layer 3. This reduces a potential barrier formed by a diffusion potential at this p-n junction, so that holes or a minority carrier from the $p^+$ drain layer 4 are injected into the $n^-$ drain layer 3, pass through the depletion region and the p base layer, and flow to the source electrode 9. When passing through the depletion region, the holes are accelerated by the electrical field in the depletion region to obtain a large kinetic energy, thereby further generating new electron-hole pairs due to impact ionization.

With the mechanism as described above, a breakdown phenomenon is induced by the p-n-p triple layer structure composed of the p base layer 7, the $n^-$ drain layer 3 and the $p^+$ drain layer 4, so that a current abruptly begins to flow between the source electrode 9 and the drain electrode 1 to suppress an increase in the voltage between the source electrode 9 and the drain electrode 1.

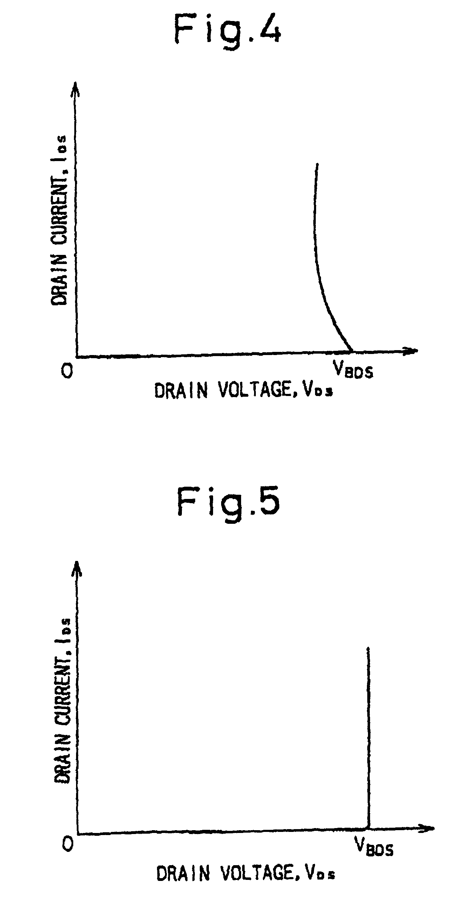

The breakdown operation is performed by a pnp triple layer bipolar transistor structure composed of the p base layer 7, the $n^-$ drain layer 3 and the $p^+$ drain layer 4. Therefore, the drain voltage $V_{BDS}$ is varied by the current amplification constant $h_{FE}$ of the pnp triple layer bipolar transistor structure composed of the p base layer 7, the $n^-$ drain layer 3 and the $p^+$ drain layer 4. In a usual bipolar transistor structure, the current amplification constant $h_{FE}$ increases with an increase in the collector current. This also true in the breakdown operation of the pnp triple layer bipolar transistor structure composed of the p base layer 7, the $n^-$ drain layer 3 and the $p^+$ drain layer 4. Namely, as the current $I_{DS}$ flowing between the drain electrode 1 and the source electrode 9 is increased, the $h_{FE}$ value of the pnp triple layer bipolar transistor structure composed of the p base layer 7, the $n^-$ drain layer 3 and the $p^+$ drain layer 4 is also increased. As a result, the source-drain voltage $V_{DS}$ is reduced with the increase in the source-drain current to exhibit a negative resistance characteristic as shown in Fig. 4, in which the drain voltage $V_{DS}$ is reduced with the increase in the drain current $I_{DS}$.

In contrast, the structure provided with the $n^+$ layer 6 as shown in Fig. 3 has an advantage that the number of holes injected from the $p^+$ drain layer 4 is restricted, so that the $h_{FE}$ value of the pnp triple layer bipolar transistor structure composed of the p base layer 7, the $n^-$ drain layer 3 and the $p^+$ drain layer 4 is reduced, thereby reducing the variation of the $h_{FE}$ value in accordance with an increase in the drain current. As a result, the reduction in the $V_{DS}$ is suppressed when the $I_{DS}$ is increased, and thus, the $V_{DS}$ can be fixed more stably.

It is more advantageous that the $n^+$ layer 6 has a periodic repeated pattern disposed over the p-n junction 5 to provide a uniform density of the current flowing through the IGBT element.

It should be appreciated that, although Fig. 3 shows an example in which the $n^+$ layer 6 is formed at the interface (or p-n junction) 5 between the $p^+$ drain layer 4 and the $n^-$ drain layer 3, the equivalent effect can be obtained even when the $n^+$ layer is formed at a position higher or lower than the interface 5. The pattern of the $n^+$ layer 6 is not limited to stripes but may be patterned as a net, for example.

In the foregoing embodiments, the breakdown voltage of the unit cell can be made lower than that of the guard ring by selecting the depth and number of the p layer 13. Alternatively, the breakdown voltage of the unit cell can be also made smaller than that of the guard ring by selectively providing a continuous $n^+$ layer 6 near the interface 5 between the $n^-$ drain layer 3 and the $p^+$ drain layer 4 of the guard ring. This can be interpreted through formula (3) as that the $h_{FE}$ of the pnp bipolar transistor of the guard ring is made smaller than the $h_{FE}$ of the pnp bipolar transistor of the unit cell to make the breakdown voltage of the unit cell higher than the breakdown voltage of the guard ring.

Although the foregoing embodiments have been described regarding an n channel type IGBT in which the first conductivity type is p-type and the second conductivity type is n-type, the present invention can also be advantageously applied to a p channel type IGBT in which the conductivity types are reversed.

**Claims**

1.  An insulated gate bipolar transistor comprising:

    a first semiconductor layer (4) of a first conductivity type;
    a second semiconductor layer (3) of a second conductivity type having an interface with said first semiconductor layer (4) and a main surface opposite said interface, a p-n junction being formed at said interface;
    a third semiconductor layer (7) of said first conductivity type formed in said second semiconductor layer (3) adjoining said main surface and forming with said second semiconductor layer (3) a p-n junction terminating at said main surface;
    a fourth semiconductor layer (8) of said second conductivity type formed in said third semiconductor layer (7) adjoining said main surface and forming with said third semiconductor layer (7) a p-n junction terminating at said main surface;
    a fifth semiconductor layer (13) of said first conductivity type formed in said second semiconductor layer (3) to surround a portion of said second semiconductor layer (3) in which said third semiconductor layer (7) is formed, adjoining said main surface and forming with said second semiconductor layer (3) a p-n junction terminating at said main surface;
    a gate electrode (10) formed on a channel region adjacent to the surface of said third semiconductor layer (7) extending between said second semiconductor layer (3) and said fourth semiconductor layer (8) via a gate insulation layer (11);
    a source electrode (9) directly contacting both of said third and fourth semiconductor layers (7 and 8); and
    a drain electrode (1) directly contacting said first semiconductor layer (4),

    *characterized in that*:

    said second semiconductor layer (3) has such an impurity concentration and such a thickness that a critical electric field that causes generation of a great number of electron-hole pairs due to impact ionization of carriers in or near said second semiconductor layer (3) thereby causing conduction between said drain electrode (1) and said source electrode (9) is established at a given drain-source voltage applied between said drain electrode (1) and said source electrode (9) causing a depletion region to extend from the p-n junction between said third semiconductor layer (7) and said second semiconductor layer (3) toward the inside of said second semiconductor layer (3), said given voltage being lower than a further drain-source voltage at which said depletion region reaches said first semiconductor layer (4) through said second semiconductor layer (3) and said given voltage being lower than a critical voltage that causes generation of a great number of electron-hole pairs due to impact ionization of carriers in or near said second semiconductor layer (3) below the p-n junction between said fifth semiconductor layer (13) and said second semiconductor layer (3).

2.  An insulated gate bipolar transistor according to claim 1, *characterized in that* a sixth semiconductor layer (7A) of said first conductivity type is formed in said second semiconductor layer (3) adjoining said main surface and forming with said second semiconductor layer (3) a p-n junction terminating at said main surface wherein said sixth semiconductor layer (7A) does not contain a semiconductor region of said second conductivity type, is directly contacted by said source electrode (9) and is located between said fifth semiconductor layer (13) and said portion of said second semiconductor layer (3).

3.  An insulated gate bipolar transistor according to claim 1 or 2, *characterized by* a seventh semiconductor layer (6) of the second conductivity type which is disposed at or near said p-n junction between said first semiconductor layer (4) and said second semiconductor layer (3), which has an impurity concentration higher than that of said second semiconductor layer (3), and which is patterned so as to leave a contact surface between said first semiconductor layer (4) and said second semiconductor layer (3) for transferring carriers theretrough.

4. An insulated gate bipolar transistor according to claim 3, *characterized in that* said seventh semiconductor layer (6) has a periodic pattern at or in the vicinity of the interface between said first semiconductor layer (4) and said second semiconductor layer (3).

5. An insulated gate bipolar transistor according to claim 3, *characterized in that* said seventh semiconductor layer (6) has a net-shaped or stripe-shaped pattern.

**Patentansprüche**

1. Isolierschicht-Bipolartransistor, der aufweist:

eine erste Halbleiterschicht (4) eines ersten Leitfähigkeitstyps;
eine zweite Halbleiterschicht (3) eines zweiten Leitfähigkeitstyps, die eine Grenzfläche zu der ersten Halbleiterschicht (4) und eine der Grenzfläche gegenüberliegende Hauptfläche aufweist, wobei an der Grenzfläche ein pn-Übergang ausgebildet ist;
eine dritte Halbleiterschicht (7) des ersten Leitfähigkeitstyps, die in der zweiten Halbleiterschicht (3) an die Hauptfläche angrenzend und mit der zweiten Halbleiterschicht (3) einen an der Hauptfläche endenden pn-Übergang ausbildend ausgebildet ist;
eine vierte Halbleiterschicht (8) des zweiten Leitfähigkeitstyps, die in der dritten Halbleiterschicht (7) an die Hauptfläche angrenzend und mit der dritten Halbleiterschicht (7) einen an der Hauptfläche endenden pn-Übergang ausbildend ausgebildet ist;
eine fünfte Halbleiterschicht (13) des ersten Leitfähigkeitstyps, die in der zweiten Halbleiterschicht (3), um einen Abschnitt der zweiten Hableiterschicht (3) zu umgeben, in welchem die dritte Halbleiterschicht (7) ausgebildet ist, an die Hauptfläche angrenzend und mit der zweiten Halbleiterschicht (3) einen an der Hauptfläche endenden pn-Übergang ausbildend ausgebildet ist;
eine Gateelektrode (10), die auf einem Kanalbereich an die Oberfläche der dritten Halbleiterschicht (7) angrenzend sich zwischen der zweiten Halbleiterschicht (3) und der vierten Halbleiterschicht (8) über eine Gateisolationsschicht (11) ausdehnend ausgebildet ist;
eine Sourceelektrode (9), die direkt beide der dritten und vierten Halbleiterschichten (7, 8) kontaktiert; und
eine Drainelektrode (1), die direkt die erste Halbleiterschicht (4) kontaktiert,

*dadurch gekennzeichnet, daß*
die zweite Halbleiterschicht (3) eine derartige Störstellenkonzentration und eine derartige Dicke aufweist, daß ein kritisches elektrisches Feld, das ein Erzeugen einer großen Anzahl von Elektronen/Lochpaaren aufgrund einer Stoßionisation von Ladungsträgern in oder in der Nähe der zweiten Halbleiterschicht (3), um dadurch eine Leitung zwischen der Drainelektrode (1) und der Sourceelektrode (9) zu bewirken, bei einer zwischen der Drainelektrode (1) und der Sourceelektrode (9) angelegten gegebenen Drain/Sourcespannung gebildet wird, die bewirkt, daß sich ein Verarmungsbereich von dem pn-Übergang zwischen der dritten Halbleiterschicht (3) zu dem Inneren der zweiten Halbleiterschicht ausdehnt, wobei die gegebene Spannung niedriger als eine weitere Drain/Sourcespannung ist, bei welcher der Verarmungsbereich über die zweite Halbleiterschicht (3) die erste Halbleiterschicht (4) erreicht, und die gegebene Spannung niedriger als eine kritische Spannung ist, die ein Erzeugen einer großen Anzahl von Elektronen/Lochpaaren aufgrund einer Stoßionisation von Ladungsträgern in oder in der Nähe der zweiten Halbleiterschicht (3) unter dem pn-Übergang zwischen der fünften Halbleiterschicht (13) und der zweiten Halbleiterschicht (3) bewirkt.

2. Isolierschicht-Bipolartransistor nach Anspruch 1, *dadurch gekennzeichnet, daß* eine sechste Halbleiterschicht (7A) des ersten Leitfähigkeitstyps in der zweiten Halbleiterschicht (3) an die Hauptfläche angrenzend und mit der zweiten Halbleiterschicht (3) einen an der Hauptfläche endenden pn-Übergang ausgebildet ist, wobei die sechste Halbleiterschicht (7A) keinen Halbleiterbereich des zweiten Leitfähigkeitstyps enthält, direkt mit der Sourceelektrode (9) verbunden ist und zwischen der fünften Halbleiterschicht (13) und dem Abschnitt der zweiten Halbleiterschicht (3) angeordnet ist.

3. Isolierschicht-Bipolartransistor nach Anspruch 1 oder 2, *gekennzeichnet durch* eine siebte Halbleiterschicht (6) des zweiten Leitfähigkeitstyps, welche an dem oder in der Nähe des pn-Übergangs zwischen der ersten Halbleiterschicht (4) und der zweiten Halbleiterschicht (3) angeordnet ist, welche eine höhere Störstellenkonzentration als die der zweiten Halbleiterschicht (3) aufweist und welche derart gemustert ist, daß eine Kontaktoberfläche zwischen der ersten Halbleiterschicht (4) und der zweiten Halbleiterschicht (3) zum Leiten von Ladungsträgern **durch** diese belassen wird.

4. Isolierschicht-Bipolartransistor nach Anspruch 3, **da***durch gekennzeichnet, daß* die siebte Halbleiterschicht (6) ein periodisches Muster an oder in der Nähe der Grenzfläche zwischen der ersten Halbleiterschicht (4) und der zweiten Halbleiterschicht (3) aufweist.

5. Isolierschicht-Bipolartransistor nach Anspruch 3, **da***durch gekennzeichnet, daß* die siebte Halbleiterschicht (6) ein netzförmiges oder streifenförmiges Muster aufweist.

**Revendications**

1. Transistor bipolaire à grille isolée comprenant :

   une première couche semi-conductrice (4) d'un premier type de conductivité ;
   une seconde couche semi-conductrice (3) d'un second type de conductivité ayant une interface avec ladite première couche semi-conductrice (4) et une surface principale opposée à ladite interface, une jonction p-n étant formée au niveau de ladite interface ;
   une troisième couche semi-conductrice (7) dudit premier type de conductivité formée dans ladite seconde couche semi-conductrice (3) attenante à ladite surface principale et formant avec ladite seconde couche semi-conductrice (3) une jonction p-n se terminant au niveau de ladite surface principale ;
   une quatrième couche semi-conductrice (8) dudit second type de conductivité formée dans ladite troisième couche semi-conductrice (7) attenante à ladite surface principale et formant avec ladite troisième couche semi-conductrice (7) une jonction p-n se terminant au niveau de ladite surface principale ;
   une cinquième couche semi-conductrice (13) dudit premier type de conductivité formée dans ladite seconde couche semi-conductrice (3) pour entourer une partie de ladite seconde couche semi-conductrice (7) dans laquelle ladite troisième couche semi-conductrice (7) est formée, attenant à ladite surface principale et formant avec ladite seconde couche semi-conductrice (3) une jonction p-n se terminant au niveau de ladite surface principale ;
   une électrode de grille (10) formée sur une région de canal adjacente à la surface de ladite troisième couche semi-conductrice (7) s'étendant entre ladite seconde couche semi-conductrice (3) et ladite quatrième couche semi-conductrice (8) via une couche d'isolement de grille (11) ;
   une électrode de source (9) contactant directement à la fois ladite troisième et ladite quatrième couche semi-conductrice (7 et 8) ; et
   une électrode de drain (1) contactant directement ladite première couche semi-conductrice (4),

   ***caractérisé en ce que*** :

   ladite seconde couche semi-conductrice (3) présente une telle concentration en impureté et une telle épaisseur que le champ électrique critique qui entraîne la génération d'un nombre important de paires d'électrons-trous dû à un impact d'ionisation des porteurs dans ou près de ladite seconde couche semi-conductrice (3) entraînant, en conséquence, la conduction entre ladite électrode de drain (1) et ladite électrode de source (9) est établi à une tension drain-source donnée appliquée entre ladite électrode de drain (1) et ladite électrode de source (9) amenant une région d'appauvrissement à s'étendre depuis la jonction p-n entre ladite troisième couche semi-conductrice (7) et ladite seconde couche semi-conductrice (3) vers l'intérieur de ladite seconde couche semi-conductrice (3), ladite tension donnée étant inférieure à une autre tension drain-source à laquelle ladite région d'appauvrissement atteint ladite première couche semi-conductrice (4) à travers ladite seconde couche semi-conductrice (3) et ladite tension donnée étant inférieure à une tension critique qui entraîne la génération d'un nombre important de paires d'électrons-trous dû à un impact d'ionisation des porteurs dans ou près de ladite seconde couche semi-conductrice (3) en dessous de la jonction p-n entre ladite cinquième couche semi-conductrice (13) et ladite seconde couche semi-conductrice (3).

2. Transistor bipolaire à grille isolée selon la revendication 1, ***caractérisé en ce qu'***une sixième couche semi-conductrice (7A) dudit premier type de conductivité est formée dans ladite seconde couche semi-conductrice (3) attenante à ladite surface principale et formant avec ladite seconde couche semi-conductrice une jonction p-n se terminant au niveau de ladite surface principale, dans lequel ladite sixième couche semi-conductrice (7A) ne contient pas de région semi-conductrice dudit second type de conductivité, est directement contactée par ladite électrode de source (9) et est positionnée entre ladite cinquième couche semi-conductrice (13) et ladite partie de ladite seconde couche semi-conductrice (3).

3. Transistor bipolaire à grille isolée selon la revendication 1 ou 2, *caractérisé par* une septième couche semi-conductrice (6) du second type de conductivité qui est disposée au niveau ou près de ladite jonction p-n entre ladite première couche semi-conductrice (4) et ladite seconde couche semi-conductrice (3), laquelle présente une concentration en impureté supérieure à celle de ladite seconde couche semi-conductrice (3), et qui est formée en motifs de façon à laisser une surface de contact entre ladite première couche semi-conductrice (4) et ladite seconde couche semi-conductrice (3) pour transfert des porteurs à travers celle-ci.

4. Transistor bipolaire à grille isolée selon la revendication 3, *caractérisé en ce que* ladite septième couche semi-conductrice (6) présente un motif périodique à ou au voisinage de l'interface entre ladite première couche semi-conductrice (4) et ladite seconde couche semi-conductrice (3).

5. Transistor bipolaire à grille isolée selon la revendication 3, *caractérisé en ce que* ladite septième couche semi-conductrice (6) présente un motif en forme de réseau ou en forme de bandes.

# Fig.1

# Fig.2

GUARD RING

UNIT CELL

n⁻ ($N_{DND}$)

P⁺

$t_e$

EP 0 622 853 B1

12

## Fig.3

# Fig.4

# Fig.5